# EUROPEAN PATENT APPLICATION

(11) **EP 1 394 702 A1**
(43) Date of publication of application: **03.03.2004**
(21) Application number: 02722701.6
(22) Date of filing: 18.04.2002
(51) Int. Cl.: G06F 17/50, H01G 4/30, H01F 17/00, H05K 3/00

(54) **HIGH-FREQUENCY ELECTRONIC COMPONENT AND ITS DESIGNING METHOD**

(30) Priority: 27.04.2001 JP 2001132605; 30.05.2001 JP 2001162904
(71) Applicant: TDK Corporation, Tokyo 103-8272 (JP)
(72) Inventor: HAYASHI, Katsuhiko, c/o TDK Corporation, Chuo-ku, Tokyo 103-8272 (JP)
(74) Representative: HOFFMANN - EITLE
(86) International application number: PCT/JP2002/003859
(87) International publication number: WO 2002/089021

(57) **Abstract**

A method for easily designing a high-frequency electronic component constituted of a multilayer substrate incorporating multiple passive elements comprises a first step of specifying parameters required by passive elements included in circuitry of a high-frequency electronic component to be fabricated, separately for each passive element, a second step of selecting the specified parameters and patterns corresponding thereto from a database storing parameters and patterns corresponding thereto of multiple passive elements, a third step of virtually laying out the selected patterns laterally (horizontally) of one another, and a fourth step of providing virtual wiring among the laid-out patterns.

## Description

### BACKGROUND OF THE INVENTION

The present invention relates to a high-frequency electronic component and a method of designing the same, particularly to a high-frequency electronic component incorporating multiple passive elements in a multilayer substrate and a method of designing the same.

### DESCRIPTION OF THE PRIOR ART

Recent telecommunications devices, typically portable phones and car phones, use large numbers of high-frequency electronic components comprising a multilayer substrate formed by stacking multiple dielectric substrates. Such a high-frequency electronic component comprises multiple passive elements, such as capacitors (C) and inductors (L), constituted of metallizations within the multilayer substrate, and high-frequency filters and other required functional elements are realized by interconnecting these passive elements.

The general practice is to form the multiple passive elements provided within the multilayer substrate on individual dielectric substrates so that the multiple passive elements come to be laid out in a stacked three-dimensional configuration.

However, when individual multiple passive elements formed within a multilayer substrate are formed by stacking layers three-dimensionally, the electric fields and magnetic fields generated by the passive elements readily interact and these interactions have to be taken into account in design of the high-frequency electronic component. But design that takes these interactions into consideration relies heavily on the experience of the designer, which is a problem because the designer is required to be highly skilled.

After the designer has decided the metallization pattern, electrical property simulation is generally conducted using a magnetic field simulator. This simulation usually takes a tremendous amount of time and this in turn prolongs the design period.

### DISCLOSURE OF THE PRESENT INVENTION

An object of the present invention is therefore to provide a high-frequency electronic component incorporating multiple passive elements in a multilayer substrate wherein interaction between passive elements is reduced.

Another object of the present invention is to provide a method enabling easy design of a high-frequency electronic component incorporating multiple passive elements in a multilayer substrate.

The method of designing a high-frequency electronic component according to the present invention comprises a first step of specifying parameters required by passive elements included in circuitry of a high-frequency electronic component to be fabricated, separately for each passive element, a second step of selecting the specified parameters and patterns corresponding thereto from a database storing parameters and patterns corresponding thereto of multiple passive elements, a third step of virtually laying out the selected patterns laterally of one another, and a fourth step of providing virtual wiring among the laid-out patterns.

In a preferred embodiment of the present invention, the patterns selected in the second step are all multilayer substrates and each multilayer substrate includes a GND layer provided with a metallization constituting a GND electrode, element forming layers formed with metallizations constituting the body of a passive element, and spacer layers provided between the GND layer and the element forming layers.

In another preferred embodiment of the present invention, once the patterns are laid out laterally of one another in the third step, the GND layers, the element forming layers and the spacer layers included in the patterns respectively form identical planes.

In another preferred embodiment of the present invention, the fourth step is conducted at least in the spacer layers included in the patterns.

In another preferred embodiment of the present invention, the multilayer substrate further comprises a cap layer provided on the side of the element forming layers opposite from the spacer layers, and wiring layers provided between the cap layer and the element forming layers.

In another preferred embodiment of the present invention, the fourth step is conducted at least in the wiring layers included in the patterns.

In another preferred embodiment of the present invention, the method of designing a high-frequency electronic component further comprises a fifth step of mounting an electronic component on the cap layer.

In another preferred embodiment of the present invention, a pattern constituting a capacitor among the patterns selected in the second step includes at least first to third metallizations each formed on one of the element forming layers, the second metallization is provided between the first metallization and the third metallization, the whole of one surface of the first metallization is substantially covered by the second metallization and the whole of one surface of the second metallization is substantially covered by the third metallization.

In another preferred embodiment of the present invention, the first metallization among the first to third metallizations is closest to the metallization constituting the GND electrode.

In another preferred embodiment of the present invention, the pattern constituting the capacitor further includes a fourth metallization provided between the first metallization and the metallization constituting the GND electrode, and the fourth metallization has an area differing from that of the first metallization.

In another preferred embodiment of the present invention, a pattern constituting a coil among the patterns selected in the second step is defined to make the relationship between the area of a region S1 of the element forming layers inward of metallizations constituting the coil body and the area of a region S2 outward thereof S2 ≥ S1.

In another preferred embodiment of the present invention, the metallizations constituting the coil body have the shape of circular sections.

In another preferred embodiment of the present invention, the planar shapes of the patterns selected in the second step are the same.

In another preferred embodiment of the present invention, the planar shapes of the patterns selected in the second step are square.

In another preferred embodiment of the present invention, a dummy region is added laterally of the patterns in the third step.

In another preferred embodiment of the present invention, the method of designing a high-frequency electronic component further comprises a sixth step of, after conducting the third step, adding an added layer provided with a metallization constituting a capacity electrode adjacent to the GND layer of each pattern.

The high-frequency electronic component according the present invention is a high-frequency electronic component constituted of a multilayer substrate incorporating multiple passive elements, characterized in that the multiple passive elements are laid out laterally of one another in the multilayer substrate.

In a preferred embodiment of the present invention, the multilayer substrate includes a GND layer formed with a GND electrode, element forming layers formed with multiple passive elements, and spacer layers provided between the GND layer and the element forming layers, all input/output terminals of the multiple passive elements being led out to the spacer layers and wired at the spacer layers.

In another preferred embodiment of the present invention, the multilayer substrate includes a GND layer formed with a GND electrode, element forming layers formed with multiple passive elements, and wiring layers provided on the side of the element forming layers opposite from the GND layer, all input/output terminals of the multiple passive elements being led out to the wiring layers and wired at the wiring layers.

In another preferred embodiment of the present invention, the multiple passive elements include a capacitor, which capacitor includes at least first to third metallizations each formed on one of the element forming layers, the second metallization is provided between the first metallization and the third metallization, the whole of one surface of the first metallization is substantially covered by the second metallization and the whole of one surface of the second metallization is substantially covered by the third metallization.

In another preferred embodiment of the present invention, the first metallization among the first to third metallizations is closest to the metallization constituting the GND electrode.

In another preferred embodiment of the present invention, the capacitor further includes a fourth metallization provided between the first metallization and the GND electrode, and the fourth metallization has an area differing from that of the first metallization.

In another preferred embodiment of the present invention, the multiple passive elements include a coil, in which coil the relationship between the area of a region S1 of the element forming layers inward of metallizations constituting the coil body and the area of a region S2 from the metallizations constituting the coil body up to the edge of the multilayer substrate or up to metallizations constituting adjacent passive elements is defined as S2 ≥ S1.

In another preferred embodiment of the present invention, the metallizations constituting the coil have the shape of circular sections.

In another preferred embodiment of the present invention, an electronic component is mounted on the upper surface of the multilayer substrate.

In another preferred embodiment of the present invention, the multilayer substrate further comprises an added layer provided adjacent to the GND electrode and formed with a capacity electrode whose mate electrode is the GND electrode.

The high-frequency electronic component according to another aspect of the present invention is a high-frequency electronic component constituted of a multilayer substrate incorporating multiple passive elements, characterized in that the multiple passive elements include a capacitor, which capacitor includes at least first to third metallizations, the second metallization is provided between the first metallization and the third metallization, the whole of one surface of the first metallization is substantially covered by the second metallization and the whole of one surface of the second metallization is substantially covered by the third metallization.

In a preferred embodiment of the present invention, the multilayer substrate includes a GND layer formed with a GND electrode over substantially the whole surface thereof and the first metallization among the first to third metallizations is closest to the GND electrode.

In another preferred embodiment of the present invention, the capacitor further includes a fourth metallization provided between the first metallization and the GND electrode, and the fourth metallization has an area differing from that of the first metallization.

The high-frequency electronic component according to another aspect of the present invention is a high-frequency electronic component constituted of a multilayer substrate incorporating multiple passive elements, characterized in that the multiple passive elements include a coil, in which coil the relationship between the area of a region S1 inward of metallizations constituting the coil body and the area of a region S2 from the metallizations constituting the coil body up to the edge of the multilayer substrate or up to metallizations constituting adjacent passive elements is defined as S2 ≥ S1.

In a preferred embodiment of the present invention, the metallizations constituting the coil body have the shape of circular sections.

### BRIEF DESCRIPTION OF THE DRAWINGS

Figure 1 is a flow chart showing a high-frequency electronic component design method that is a preferred embodiment of the present invention.
Figure 2 is a simplified exploded perspective view showing an example of a capacitor pattern 10 decided in step S10.
Figure 3 is a simplified sectional view of the capacitor 10 shown in Figure 2.
Figure 4 is a simplified exploded perspective view showing an example of a coil pattern 30 decided in step S10.
Figure 5 is a simplified see-through plan view of the coil pattern shown in Figure 4.
Figure 6 is a simplified exploded perspective view showing an example of a coil pattern 30' decided in step S10.
Figure 7 is a simplified see-through plan view of the coil pattern 30' shown in Figure 6.
Figure 8 is an example of the circuitry of a high-frequency electronic component to be fabricated by the method of the present embodiment.
Figure 9 is an example showing the layout of the passive elements C0 - C2 and L0 of the low-pass filter shown in Figure 8.
Figure 10 is an exploded perspective view showing the structure of the low-pass filter circuit shown in Figures 8 and 9 in the wired state.
Figure 11 is a simplified exploded perspective view showing an example of a capacitor pattern 130 decided in step S10.
Figure 12 is a simplified exploded perspective view showing an example of a coil pattern 150 decided in step S10.
Figure 13 is an exploded perspective view showing the structure of the low-pass filter circuit shown in Figures 8 and 9 in the wired state.
Figure 14 is an exploded perspective view showing an example of an electronic component 165 mounted on a cap layer.
Figure 15 is an example of the layout of a high-frequency electronic component 50 composed of three passive elements 51 - 53.
Figure 16 is an example of the layout of a high-frequency electronic component 60 composed of five passive elements 61 - 65.
Figure 17 is an example of the layout of a high-frequency electronic component 70 composed of eight passive elements 71 - 78.
Figure 18 is an example of the layout of a high-frequency electronic component 80 composed of a passive element 81 selected from a series whose members measure 1.0 mm per side and passive elements 82, 83 selected from a series whose members measure 0.5 mm per side.
Figure 19 is an example of the layout of a high-frequency electronic component 90 composed of passive elements 91 - 93 selected from a series whose members measure 0.5 mm per side and a passive element 94 selected from a series whose members measure 0.3 mm per side.
Figure 20 is an example of the layout of a high-frequency electronic component 100 composed of passive elements 101 - 103 selected from a series whose members measure 0.5 mm per side and a passive element 104 selected from a series whose members measure 0.8 mm per side.
Figure 21 is an example of the layout of a high-frequency electronic component 110 composed of six passive elements 111 - 116 all of which have a rectangular planar shape.
Figure 22 is an example of the layout of a high-frequency electronic component 120 composed of a passive element 121 selected from a series whose members measure 0.5 mm per side (square type), a passive element 122 selected from a series whose members measure 0.3 mm per side (square type), and rectangular type passive elements 122, 123 whose sides measure 0.5 mm x 0.3 mm.
Figure 23 is a simplified sectional view showing a capacitor pattern 170 using five element forming layers.
Figure 24 is a simplified sectional view showing a capacitor pattern 180 using five element forming layers.
Figure 25 is an exploded perspective view showing a high-frequency electronic component 190 imparted with ground capacity.

### DESCRIPTION OF THE PREFERRED EMBODIMENTS

Preferred embodiments of the present invention will now be described in detail with reference to the accompany drawings.

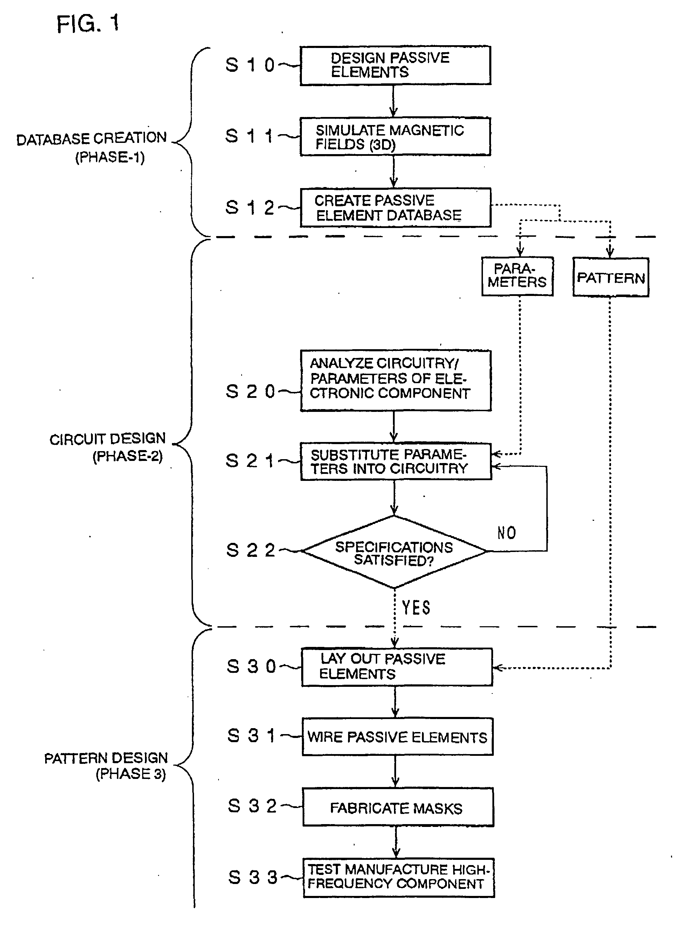

Figure 1 is a flow chart showing a high-frequency electronic component design method that is a preferred embodiment of the present invention.

As shown in Figure 1, the method of designing a high-frequency electronic component according to this embodiment consists of three phases: a database creation (phase-1), a circuit design (phase-2) and a pattern design (phase 3). These phases will be explained in detail in the following.

The database creation (phase-1) will be explained first.

The database creation (phase-1) is a phase for compiling the circuit constants of multiple passive elements and structures corresponding thereto into a database. A designer first decides virtual structures for multiple passive elements (step S10).

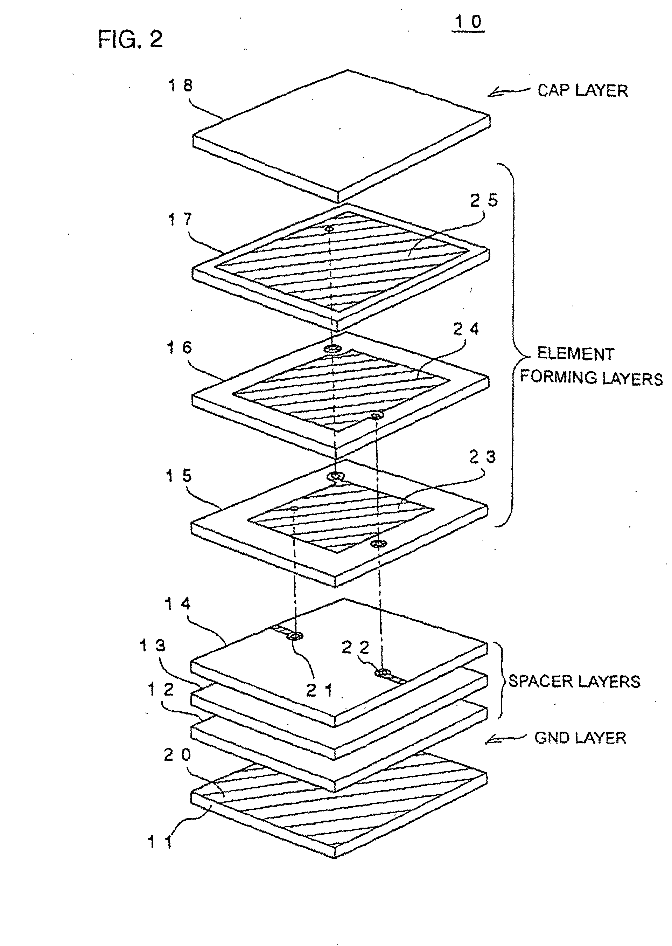

Figure 2 is a simplified exploded perspective view showing an example of a capacitor pattern 10 decided in step S10.

As shown in Figure 2, the capacitor pattern 10 comprises eight dielectric substrates 11 - 18 of square planar shape and metallizations formed on prescribed ones of the dielectric substrates. Among the dielectric substrates 11 - 18, the bottommost dielectric substrate 11 is a GND layer whose upper surface is virtually formed with a metallization 20 constituting a GND electrode. Further, the dielectric substrates 12 - 14 above the dielectric substrate 11 among the dielectric substrates 11 - 18 constitute spacer layers. Portions of the surface of the dielectric substrate 14 are virtually formed with metallizations 21, 22 constituting lead electrodes of input/output terminals and the remaining portion is not formed with metallization. The dielectric substrates 15 - 17 above the dielectric substrate 14 constitute element forming layers. The dielectric substrate 15 is virtually formed with a metallization 23 constituting part of one electrode of a capacitor, the dielectric substrate 16 is virtually formed with a metallisation 24 constituting the other electrode of the capacitor, and the dielectric substrate 17 is virtually formed with a metallization 25 constituting part of the one electrode of the capacitor. As shown in Figure 2, the metallization 23 formed on the dielectric substrate 15 and the metallization 25 formed on the dielectric substrate 17 are shorted together by through-hole wiring virtually formed in the dielectric substrates 16, 17, the metallization 23 formed on the dielectric substrate 15 and the metallization 21 formed on the dielectric substrate 14 are shorted together by through-hole wiring virtually formed in the dielectric substrate 15, and the metallization 24 formed on the dielectric substrate 16 and the metallization 22 formed on the dielectric substrate 14 are shorted together by through-hole wiring virtually formed in the dielectric substrates 15, 16. The dielectric substrate 18 above the dielectric substrate 17 is a cap layer not formed with any metallization.

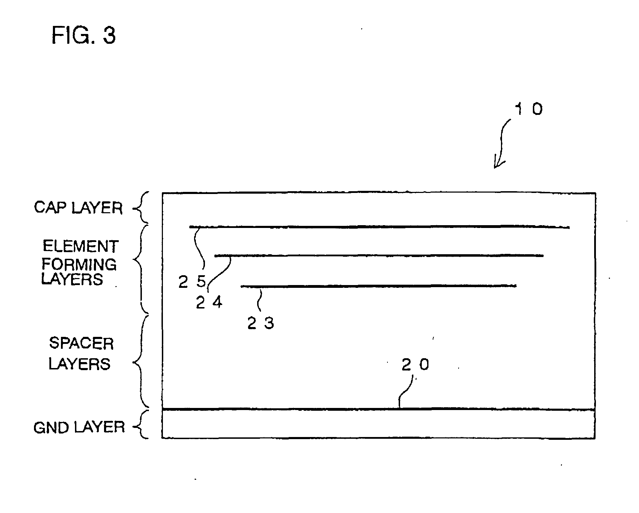

Figure 3 is a simplified sectional view of the capacitor 10 shown in Figure 2.

As shown in Figure 3, among the metallizations 23 - 25 constituting the capacitor electrodes in the capacitor pattern 10, the metallization 23 closest to the metallization 20 constituting the GND electrode is given the smallest area and the metallization 25 farthest from metallization 20 is given the largest area. In other words, the whole of one surface of the metallization 24 is substantially covered by the metallization 25 and the whole of one surface of the metallization 23 is substantially covered by the metallization 24. As a result, the electric field generated at the edges of the capacitor electrodes constituted by the metallizations 23 - 25 is directed inward to effectively keep it from leaking laterally (horizontally). As termed with respect to the present invention, "laterally (horizontally)" means in the direction of extensions of the major surfaces of the dielectric substrates constituting the high-frequency electronic component, i.e., in the direction perpendicular to the stacking direction of the dielectric substrates. This structure therefore makes it possible to keep interaction between the capacitor electrodes and other circuit elements very small even when other circuit elements are disposed laterally (horizontally) of the capacitor electrodes.

Moreover, owing to the aforesaid structure of the metallizations 23 - 25 constituting the capacitor electrodes, any displacement of the metallizations 23 - 25 that might arise in the actual product can be prevented from causing a change in the capacitance value. In addition, the capacitance value between the metallization 20 constituting the GND electrode and each of the metallizations 23 - 25 can be made substantially equal so as to make the impedance of the two input/output terminals 21, 22 substantially the same.

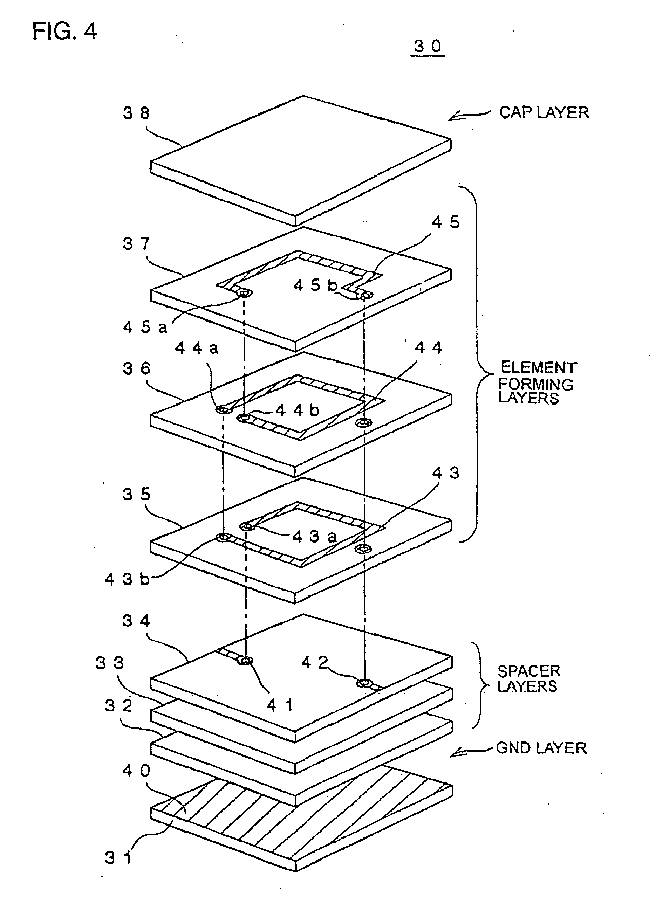

Figure 4 is a simplified exploded perspective view showing an example of a coil pattern 30 decided in step S10.

As shown in Figure 4, the coil pattern 30, similarly to the capacitor pattern 10, comprises eight dielectric substrates 31 - 38 of square planar shape measuring the same length per side as the capacitor pattern 10 and metallizations formed on prescribed ones of the dielectric substrates. Among the dielectric substrates 31 - 38, the bottommost dielectric substrate 31 is a GND layer whose upper surface is virtually formed with a metallization 40 constituting a GND electrode. Further, the dielectric substrates 32 - 34 above the dielectric substrate 31 among the dielectric substrates 31 - 38 constitute spacer layers. Portions of the surface of the dielectric substrate 34 are virtually formed with metallizations 41, 42 constituting lead electrodes of input/output terminals and the remaining portion is not formed with metallization. The dielectric substrates 35 - 37 above the dielectric substrate 34 constitute element forming layers. The dielectric substrates 35 - 37 are virtually formed with metallizations 43-45, respectively.

As shown in Figure 4, one end 43a of the metallization 43 formed on the dielectric substrate 35 and the metallization 41 formed on the dielectric substrate 34 are shorted together by through-hole wiring virtually formed in the dielectric substrate 35, the other end 43b of the metallization 43 formed on the dielectric substrate 35 and one end 44a of the metallization 44 formed on the dielectric substrate 36 are shorted together by through-hole wiring virtually formed in the dielectric substrate 36, the other end 44b of the metallization 44 formed on the dielectric substrate 36 and one end 45a of the metallization 45 formed on the dielectric substrate 37 are shorted together by through-hole wiring virtually formed in the dielectric substrate 37, and the other end 45b of the metallization 45 formed on the dielectric substrate 37 and the metallization 42 formed on the dielectric substrate 34 are shorted together by through-hole wiring virtually formed in the dielectric substrates 35 - 37. The dielectric substrate 38 above the dielectric substrate 37 is a cap layer not formed with any metallization.

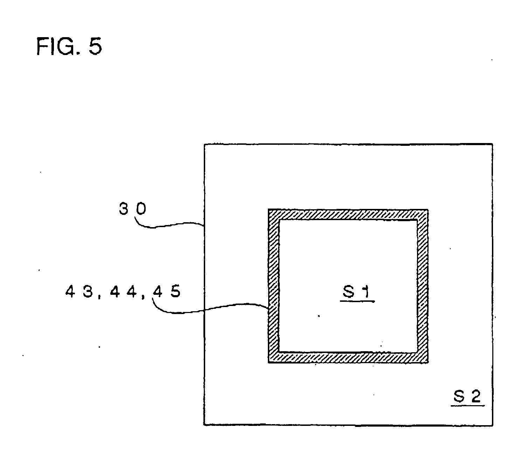

Figure 5 is a simplified see-through plan view of the coil pattern shown in Figure 4.

As shown in Figure 5, in the coil pattern 30, the relationship between the area of a region S1 enclosed by the metallizations 43 - 45 constituting the coil and the area of a region S2 outside thereof (extending to the edges of the dielectric substrates) is defined so that S2 ≥ S1. As this ensures that most of the magnetic field generated in the region S1 passes through the region S2, it effectively reduces leakage of the magnetic field laterally (horizontally). When S1 > S2, the flux density of the magnetic field is maximum in the region S1 so that a magnetic field of equal or greater flux density cannot be produced in the region S2. Much of the magnetic field leaks outside the region S2 as a result.

Therefore, by defining S2 ≥ S1, interaction between the coil pattern 30 and other circuit elements is kept very small even when other circuit elements are disposed laterally (horizontally) of the coil pattern 30.

Although the region enclosed by the metallizations 43 - 45 is square in the coil pattern 30 shown in Figures 4 and 5, it can instead be circular.

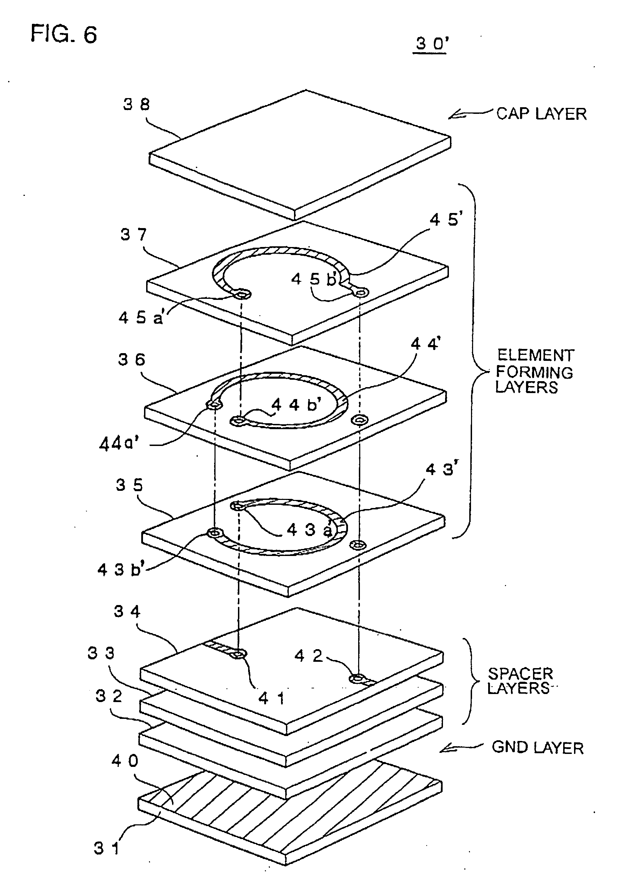

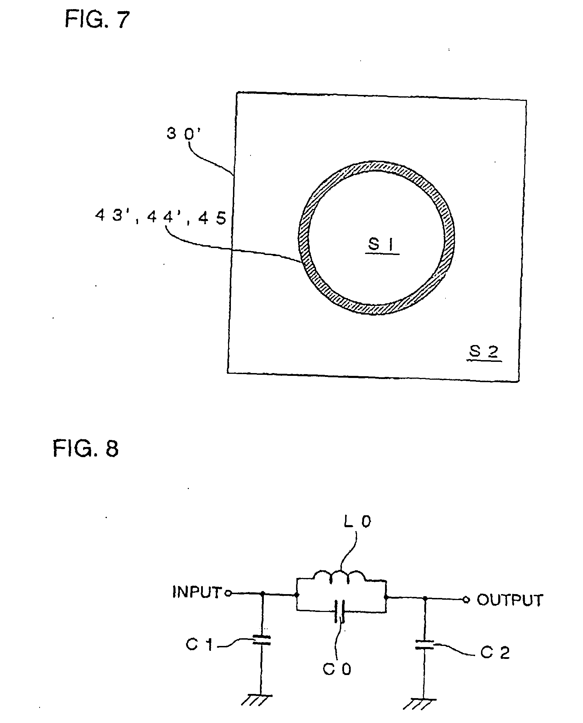

Figure 6 is a simplified exploded perspective view showing a coil pattern 30' as an example wherein metallizations 43' - 45' on the dielectric substrates 35 - 37 are given the shape of circular sections to make the shape of the region enclosed by the metallizations 43' - 45' round (circular). Figure 7 is a simplified see-through plan view of the coil pattern 30' shown in Figure 6.

Also in the coil pattern 30', the relationship between the area of a region S1 enclosed by the metallizations 43'- 35'constituting the coil and the area of a region S2 outside thereof (extending to the edges of the dielectric substrates) is defined so that S2 ≥ S1. The effect of this is the same as that in the coil pattern 30 explained above. Moreover, when one or more other circuit elements are disposed laterally (horizontally) of the coil pattern 30', the circular shape of the metallizations 43' - 45' in the coil pattern 30 ensures that the edges of the metallizations 43' - 45' do not lie parallel to the edges of metallizations constituting the other circuit elements. An effect of weakening magnetic coupling with the other circuit elements can therefore be realized. The circular shape of the metallizations 43' - 45' in the coil pattern 30' also prevents high-frequency current from concentrating locally, thereby producing a coil Q value enhancing effect.

As explained in the foregoing, the structure of a prescribed passive element comprising one GND layer, three spacer layers, three element forming layers, and one cap layer is decided in step S10.

Once a passive element structure has been decided in step S10, the structure is next input to a magnetic field simulator in which magnetic field simulation is conducted (step S11). In the magnetic field simulation, the circuit constants of the passive element having the structure input by the designer are calculated. Specifically, the S parameters of the input/output terminals in a prescribed-frequency band are calculated. The magnetic field distribution of the metallization pattern formed on the dielectric substrates, which is in accordance with the Maxwell equations, is calculated using the finite-element method or the like. Since the passive element subjected to the simulation has a three-dimensional pattern structure such as shown in Figures 2 to 7, it is preferable to utilize a 3D magnetic field simulator.

Differently from the whole-circuit magnetic field simulation conducted in the conventional high-frequency electronic component design method, the magnetic field simulation of step S11 is conducted on the individual passive elements and therefore, differently from the conventional magnetic field simulation, almost never takes a great amount of time.

Since the magnetic field simulation of step S11 provides the circuit constants (parameters) of the passive element and the structure (pattern) corresponding thereto, a database can be created (step S12) by repeating it a number of times.

In this case, even when a capacitor pattern whose characteristics differ from those of the capacitor pattern 10 is to be registered in the database, it is preferable, as was explained regarding the capacitor pattern 10, to define the metallizations 23 - 25 constituting the capacitor electrodes such that the area of the metallization 23 closest to the metallization 20 constituting the GND electrode is the smallest and the area of the metallization 25 farthest from the metallization 20 is largest. This makes it possible to ensure that all of the capacitors registered in the database are ones in which lateral (horizontal) leakage of electric field is effectively reduced. However, this electrode structure is not absolutely necessary in the case of a capacitor that leaks very little electric field laterally (horizontally) even though not having the aforesaid electrode structure.

Similarly, when a coil pattern whose characteristics differ from those of the coil pattern 30 is to be registered in the database, it is preferable, as was explained regarding the coil pattern 30, to define the pattern so that S2 ≥ S1. This makes it possible to ensure that all of the coils registered in the database are ones in which lateral (horizontal) leakage of magnetic field is effectively reduced.

By the foregoing, it is possible to ensure that all of the passive elements recorded in the database are ones that have small interaction in the lateral (horizontal) direction.

The circuit design (phase-2) will now be explained.

The circuit design (phase2) is a phase for deciding the circuit element structure (circuitry) of the high-frequency electronic component to be fabricated. First, the circuitry of the high-frequency electronic component to be fabricated is input to a circuit simulator in which the circuit constants (S parameters) of the passive elements constituting the circuitry are calculated to enable the input circuitry to have the required electrical characteristics (step S20). Specifically, the circuitry simulator substitutes constants into the individual circuit elements constituting the input circuitry calculates their electrical characteristics, and uses an optimizing feature called an optimizer to find the constant values that the individual circuit elements constituting the circuitry need to enable the input circuitry to have the required electrical characteristics.

Figure 8 is an example of the circuitry of a high-frequency electronic component to be fabricated by the method of the present embodiment.

The circuit shown in Figure 8 is a low-pass filter circuit composed of three capacitors C0 - C2 and one coil L0. Therefore, when the circuitry of the high-frequency electronic component to be fabricated has this configuration, the required circuit element values are found for each of the three capacitors C0 - C2 and the coil L0.

The S parameters of the circuit are thus calculated for the constant values of the individual passive elements composing the circuitry. Passive elements having the S parameters calculated in step S20 are selected from among the passive elements registered in the database created in the database creation (phase-1) and the selected passive elements are substituted into the circuitry (step S21). When no passive element having the S parameters calculated for the circuit element in step S20 is registered in the database, it suffices to select two passive elements having S parameters near the parameters calculated in step S20 from among the passive elements registered in the database and then either to use an interpolation method or the like to create the parameters and a corresponding pattern thereto or to return to the database creation (phase-1) and make a new registration.

Next, the circuitry simulator is again used to calculate the electrical characteristics of the whole circuitry for which substitution has been completed and a judgment is made as to whether the specifications required of the high-frequency electronic component to be fabricated are satisfied (step S22).

When it is judged that the specifications are not satisfied, the procedure goes back to S21 to select different passive elements from among those registered in the database and repeat the substitution into the circuitry. On the other hand, when it is judged that the specifications are satisfied, the circuit design (phase2) is completed and the procedure passes to pattern the design (phase 3).

The pattern design (phase 3) will now be explained.

The pattern design (phase 3) is a phase for actually fabricating the high-frequency electronic component. First, the passive elements whose use was decided in the circuit design (phase2) are selected from among the passive elements registered in the database created in the database creation (phase-1) and their patterns are virtually laid out laterally (horizontally) (step 30).

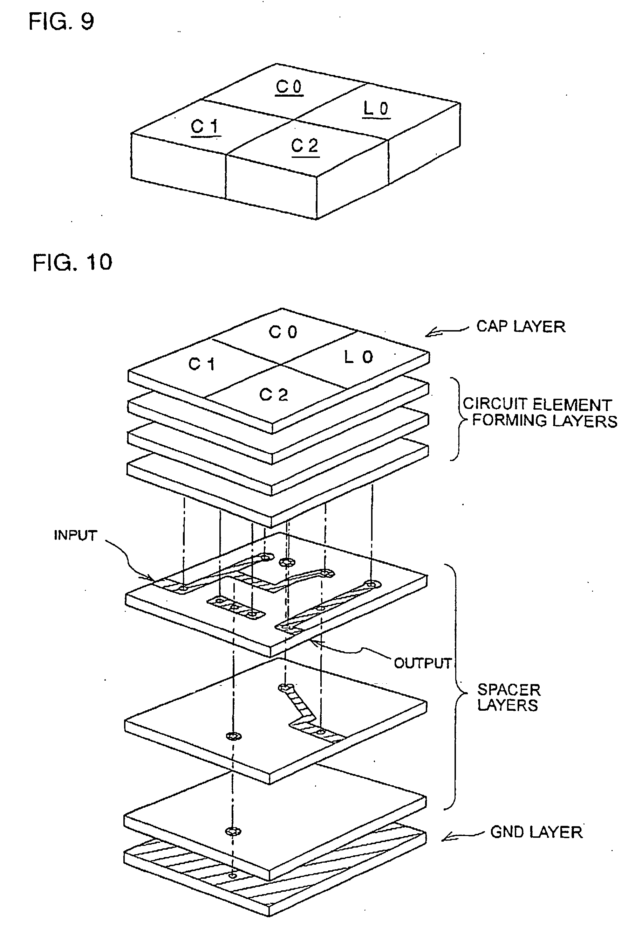

Figure 9 is an example showing the layout of the passive elements C0 - C2 and LO of the low-pass filter shown in Figure 8.

The important point in step S30 is that, as shown in Figure 9, the passive elements used are laid out laterally (horizontally) of one another. Owing to the fact that, as explained earlier, the passive elements registered in the database are of square planar shape, layout of the passive elements C0 - C2 and L0 in various combinations is possible. The passive elements registered in the database all have the same layer structure consisting of one GND layer, three spacer layers, three element forming layers and one cap layer. Therefore, when the passive elements are laid out laterally (horizontally) of one another as shown in Figure 9, the GND layers, spacer layers, element forming layers and cap layers constituting the passive elements are respectively all located in the same plane.

Once the virtual layout of the passive elements has been completed in this manner, virtual wiring is formed among the passive elements (step S31).

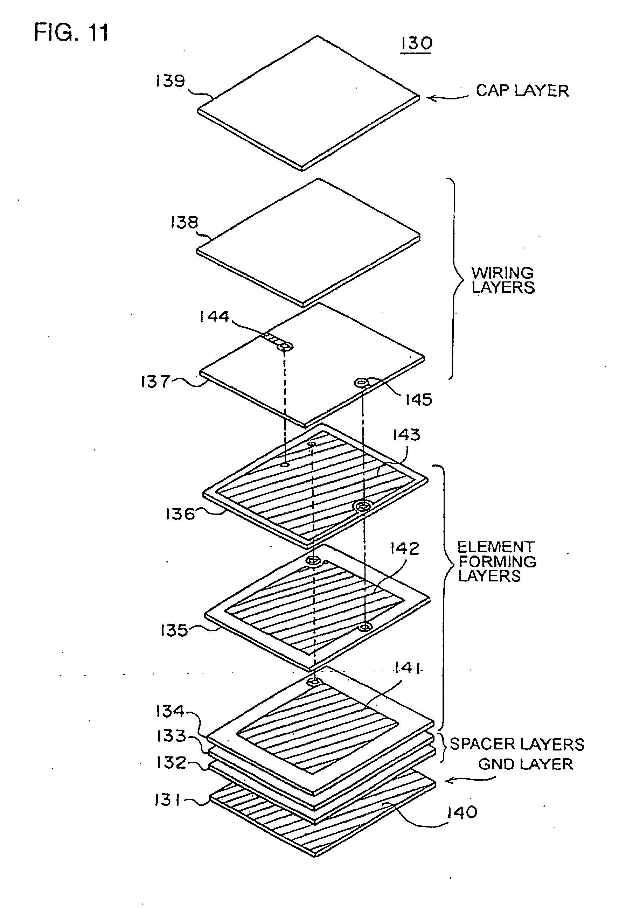

Figure 10 is an exploded perspective view showing the structure of the low-pass filter circuit shown in Figures 8 and 9 in the wired state.

As shown in Figure 10, the wiring among the passive elements is conducted using the spacer layers and no wiring is formed on the element forming layers. This enables the wiring among the passive elements to be conducted without giving any substantial consideration to change in the parameters of the passive elements. The foregoing steps decide the overall structure of the high-frequency electronic component to be fabricated.

Once the overall structure of the high-frequency electronic component to be fabricated has been decided, masks are actually fabricated based thereon (step 32) and the high-frequency electronic component is actually fabricated using the masks (step 33).

Since the so-fabricated high-frequency electronic component comprises passive elements of small lateral (horizontal) interaction laid out laterally (horizontally) of one another, interaction among the passive elements is very slight. As explained in the foregoing, therefore, the entire structure of the high-frequency electronic component to be fabricated can be obtained, without need for concern about interaction among the passive elements, merely by virtually laying out passive elements registered in the database (step S30) and using the spacer layers to interconnect the passive elements with wiring (step S31).

The high-frequency electronic component design method of this embodiment can therefore be conducted without depending on the experience of a designer and, as such, enables a high-frequency electronic component to be designed without relying on a skilled designer. It further allows design of a high-frequency electronic component in a short period of time because there is no need to conduct magnetic field simulation on the whole high-frequency electronic component.

The foregoing embodiment was explained taking the case of designing a low-pass filter as an example. However, also in the case of fabricating various other kinds of high-frequency components, the availability of the database created in the database creation (phase-1) enables simple and rapid design of other high-frequency electronic components in a variety of types that increases with the number of registered passive elements.

Another preferred embodiment of the present invention will now be explained.

The high-frequency electronic component design method of this embodiment is basically the same as the high-frequency electronic component design method of the embodiment described above (see Figure 1), but differs therefrom in the designing of passive elements (step S10) in the database creation (phase-1) and the provision of wiring among the passive elements (step S31) in the pattern design (phase 3). Specifically, the passive element structures recorded in the database and the method of forming wiring among the passive elements in this embodiment differ from those of the foregoing embodiment.

Figure 11 is a simplified exploded perspective view showing an example of a capacitor pattern 130 decided in step S10 in this embodiment.

As shown in Figure 11, the capacitor pattern 130 comprises nine dielectric substrates 131 - 139 of square planar shape and metallizations formed on prescribed ones of the dielectric substrates. Among the dielectric substrates 131-139, the bottommost dielectric substrate 131 is a GND layer whose upper surface is virtually formed with a metallization 140 constituting a GND electrode. Further, the dielectric substrates 132, 133 above the dielectric substrate 131 among the dielectric substrates 131 - 139 constitute spacer layers, neither of which is metallized. The dielectric substrates 134 - 136 above the dielectric substrate 133 constitute element forming layers. The dielectric substrate 134 is virtually formed with a metallization 141 constituting part of one electrode of a capacitor, the dielectric substrate 135 is virtually formed with a metallization 142 constituting the other electrode of the capacitor, and the dielectric substrate 136 is virtually formed with a metallization 143 constituting part of the one electrode of a capacitor. The dielectric substrates 137, 138 above the dielectric substrate 136 are wiring layers, and the upper surface of the dielectric substrate 137 is virtually formed with metallizations 144, 145 constituting lead electrodes of input/output terminals.

As shown in Figure 11, the metallization 141 formed on the dielectric substrate 134 and the metallization 143 formed on the dielectric substrate 136 are shorted together by through-hole wiring virtually formed in the dielectric substrates 135, 136, the metallization 143 formed on the dielectric substrate 136 and the metallization 144 formed on the dielectric substrate 137 are shorted together by through-hole wiring virtually formed in the dielectric substrate 137, and the metallization 142 formed on the dielectric substrate 135 and the metallization 145 formed on the dielectric substrate 137 are shorted together by through-hole wiring virtually formed in the dielectric substrates 136, 137. The dielectric substrate 139 above the dielectric substrate 138 is a cap layer not formed with any metallization.

Among the metallizations 141- 143 constituting the capacitor electrodes in the capacitor pattern 130 shown in Figure 11, the metallization 141 closest to the metallization 140 constituting the GND electrode is given the smallest area and the metallization 143 farthest from metallization 140 is given the largest area. In other words, the whole of one surface of the metallization 142 is substantially covered by the metallization 143 and the whole of one surface of the metallization 141 is substantially covered by the metallization 142. Therefore, also in the capacitor pattern 130, as in the capacitor pattern 10 described earlier, the electric field generated at the edges of the capacitor electrodes constituted is directed inward to effectively keep it from leaking laterally (horizontally) and any displacement of the metallizations 141 - 143 that might arise in the actual product can be prevented from causing a change in the capacitance value. In addition, the capacitance value between the metallization 140 constituting the GND electrode and each of the metallizations 141 - 143 can be made substantially equal so as to make the impedance of the two input/output terminals 144, 145 substantially the same.

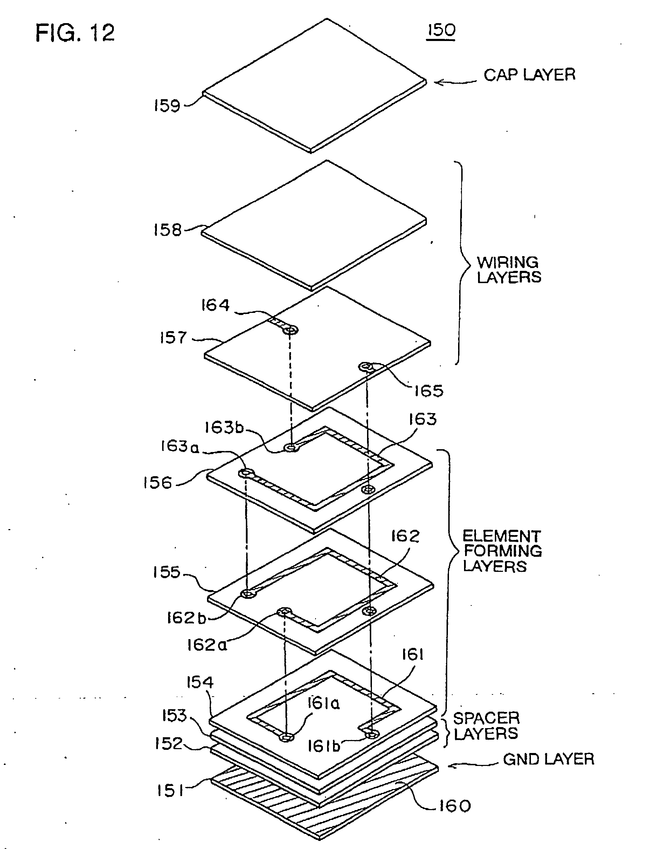

Figure 12 is a simplified exploded perspective view showing an example of a coil pattern 150 decided in step S10 of this embodiment.

As shown in Figure 12, the coil pattern 150, similarly to the capacitor pattern 130, comprises nine dielectric substrates 151 - 159 of square planar shape measuring the same length per side as the capacitor pattern 130 and metallizations formed on prescribed ones of the dielectric substrates. Among the dielectric substrates 151 - 159, the bottommost dielectric substrate 151 is a GND layer whose upper surface is virtually formed with a metallization 160 constituting a GND electrode. Further, the dielectric substrates 152, 153 above the dielectric substrate 151 among the dielectric substrates 151 - 159 constitute spacer layers, neither of which is metallized. The dielectric substrates 154 - 156 above the dielectric substrate 153 constitute element forming layers. The dielectric substrates 154 - 156 are virtually formed with metallizations 161 - 163, respectively. The dielectric substrates 157, 158 above the dielectric substrate 156 are wiring layers, and the upper surface of the dielectric substrate 157 is virtually formed with metallizations 164, 165 constituting lead electrodes of input/output terminals.

As shown in Figure 12, one end 161a of the metallization 161 formed on the dielectric substrate 154 and one end 162a of the metallization 162 formed on the dielectric substrate 155 are shorted together by through-hole wiring virtually formed in the dielectric substrate 155, the other end 162b of the metallization 162 formed on the dielectric substrate 155 and one end 163a of the metallization 163 formed on the dielectric substrate 156 are shorted together by through-hole wiring virtually formed in the dielectric substrate 156, the other end 163b of the metallization 163 formed on the dielectric substrate 156 and the metallization 164 formed on the dielectric substrate 157 are shorted together by through-hole wiring virtually formed in the dielectric substrate 157, and the other end 161b of the metallization 161 formed on the dielectric substrate 154 and the metallization 165 formed on the dielectric substrate 157 are shorted together by through-hole wiring virtually formed in the dielectric substrates 155 - 157. The dielectric substrate 159 above the dielectric substrate 158 is a cap layer not formed with any metallization.

Also in the coil pattern 150 shown in Figure 12, the relationship between the area of a region S1 enclosed by the metallizations 161 - 163 constituting the coil and the area of a region S2 outside thereof (extending to the edges of the dielectric substrates) is defined so that S2 ≥ S1. Thus, also in the coil pattern 150, as in the coil pattern 30, leakage of the magnetic field laterally (horizontally) is effectively reduced.

Although the region S1 enclosed by the metallizations 161 - 163 forming the coil is square in the coil pattern 150 shown in Figure 12, it can instead be made circular by giving the metallizations constituting the coil a round shape as in the coil pattern 30' shown in Figures 6 and 7. The effect of making the metallizations 161 - 163 constituting the coil round is the same as mentioned earlier.

As explained in the foregoing, in this embodiment, the structure of a prescribed passive element comprising one GND layer, two spacer layers, three element forming layers, two wiring layers and one cap layer is decided in step S10.

The passive elements having such a structure are, similarly to in the preceding embodiment, subjected to magnetic field simulation (step S11) so as to create a database (step S12) including circuit constants (parameters) and corresponding structures (patterns) for various passive elements.

In the circuit design (phase2), the circuit element structure (circuitry) of the high-frequency electronic component to be fabricated is decided by the same method as explained regarding the preceding embodiment. Once the circuit design (phase2) has been completed, the pattern design (phase 3) is then conducted. In this embodiment, too, the passive elements whose use was decided in the circuit design (phase-2) are first selected from among the passive elements registered in the database created in the database creation (phase-1) and their patterns are virtually laid out laterally (horizontally) (step 30).

For instance, when the passive elements C0 - C2 and L0 constituting the low-pass filter shown in Figure 8 are to be laid out, the passive elements used are laid out laterally (horizontally) of one another as shown in Figure 9. In this embodiment, the passive elements registered in the database all have the same layer structure consisting of one GND layer, two spacer layers, three element forming layers, two wiring layers and one cap layer. Therefore, when the passive elements are laid out laterally (horizontally) of one another as shown in Figure 9, the GND layers, spacer layers, element forming layers, wiring layers and cap layers constituting the passive elements are respectively all located in the same plane.

Once the virtual layout of the passive elements has been completed in this manner, virtual wiring is formed among the passive elements (step S31).

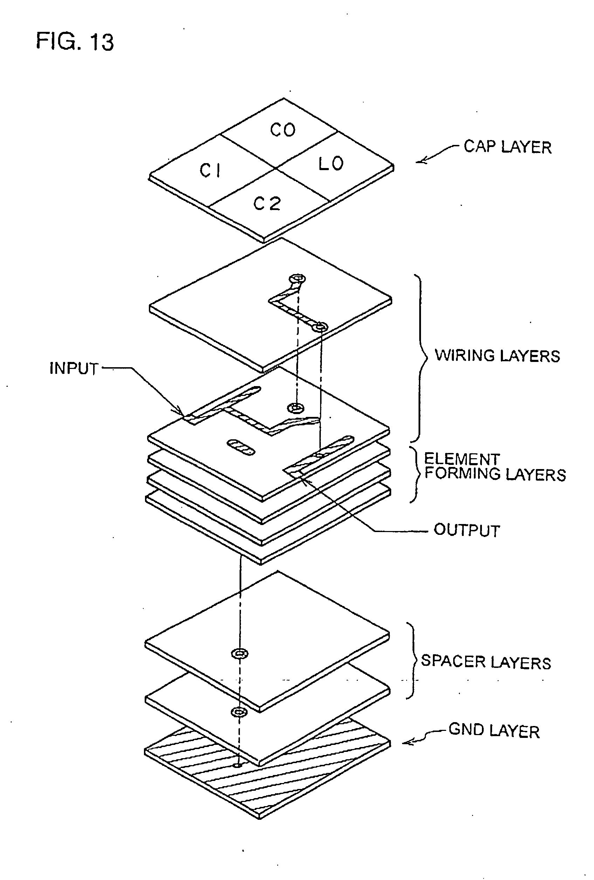

Figure 13 is an exploded perspective view showing the structure of the low-pass filter circuit shown in Figures 8 and 9 in the wired state.

As shown in Figure 13, in this embodiment the wiring among the passive elements is conducted using the wiring layers, the GND wiring is constituted by through-hole wiring provided in the spacer layers, and no wiring is formed on the element forming layers. This enables the wiring among the passive elements to be conducted without giving any substantial consideration to change in the parameters of the passive elements. The foregoing steps decide the overall structure of the high-frequency electronic component to be fabricated.

Once the overall structure of the high-frequency electronic component to be fabricated has been decided, masks are actually fabricated based thereon (step 32) and the high-frequency electronic component is actually fabricated using the masks (step 33).

Since the high-frequency electronic component fabricated in accordance with this embodiment also comprises passive elements of small lateral (horizontal) interaction laid out laterally (horizontally) of one another, interaction among the passive elements is very slight and the same effects as in the preceding embodiment are obtained.

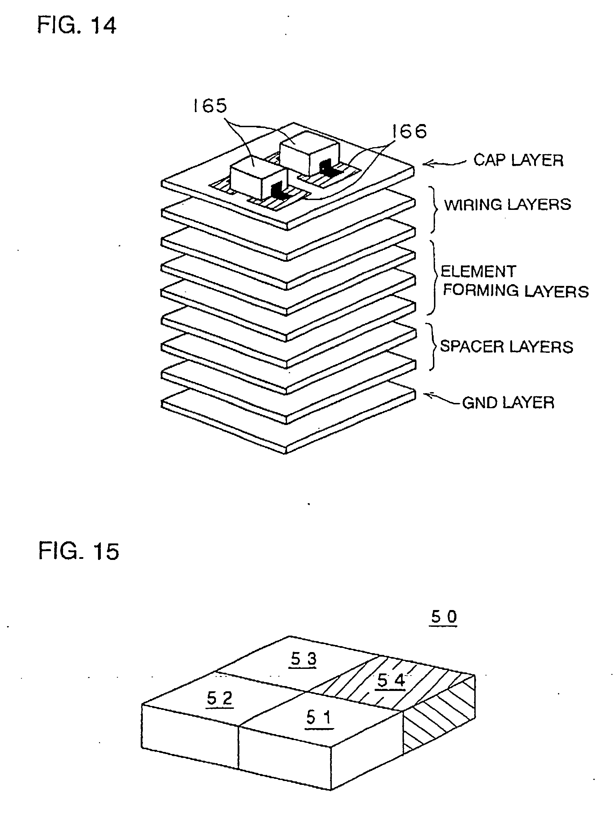

Moreover, the wiring among the passive elements is provided using the wiring layers located between the cap layer and the element forming layers in this embodiment. Therefore, when one or more active elements such as PIN diodes, discrete components such as capacitors, coil or resistors, or any of various other electronic components 165 are mounted on the upper surface (cap layer) of the high-frequency electronic component as shown in Figure 14, the components 165 and the passive elements formed on the element forming layers can be easily wired. Although the mounting of components 165 on the upper surface (cap layer) of the high-frequency electronic component makes it necessary to provided pad electrodes 166 for the mounted components on the upper surface (cap layer) of the high-frequency electronic component, the effect of the pad electrodes 166 on the passive elements formed in the element forming layers is minimized in this embodiment because the wiring layers are present between the cap layer and the element forming layers.

In the capacitor pattern 130 shown in Figure 11, although metallizations (141 - 143) constituting the capacitor electrodes are formed on of the three dielectric substrates 134 - 136 serving as the element forming layers, there is no need in the case of a capacitor pattern of small circuit constants to use all of the three dielectric substrates 134 - 136 serving as the element forming layers and it suffices to form metallizations on only the two dielectric substrates 135, 136 on the upper side. Likewise, in the coil pattern 150 shown in Figure 12, although metallizations (161 - 163) constituting the coil electrodes are formed on all of the three dielectric substrates 154 - 156 serving as the element forming layers, there is no need in the case of a coil pattern of small circuit constants to use all of the three dielectric substrates 154 - 156 serving as the element forming layers and it suffices to form metallizations on only the uppermost dielectric substrate 156 or on only the two dielectric substrates 155, 156 on the upper side. In such a case, the number of through-holes required for lead-out to the metallizations (144, 145; 164, 165) constituting the lead electrodes of one or the other of the capacitor and coil can be reduced because in this embodiment these metallizations are formed on a wiring layer located above the element forming layers.

In the low-pass filter circuit shown in Figure 13, GND wiring composed of through-holes is provided in the spacer layers. However, if the circuit configuration does not require GND wiring, such through-holes need not be provided in the spacer layers.

The foregoing embodiments were explained taking as an example the case of designing a low-pass filter composed of four passive elements. However, in cases where the number of passive elements used makes it impossible to achieve an overall quadrilateral layout, it suffices to deal with the situation as explained in the following.

Figure 15 is an example of the layout of a high-frequency electronic component 50 composed of three passive elements 51- 53.

As shown in Figure 15, the high-frequency electronic component 50 composed of three passive elements 51 - 53 can be given a quadrilateral planar shape overall by adding a dummy region 54. The dummy region 54 is provided with a GND electrode on its bottommost dielectric substrate but the other dielectric substrates thereof are not metallized.

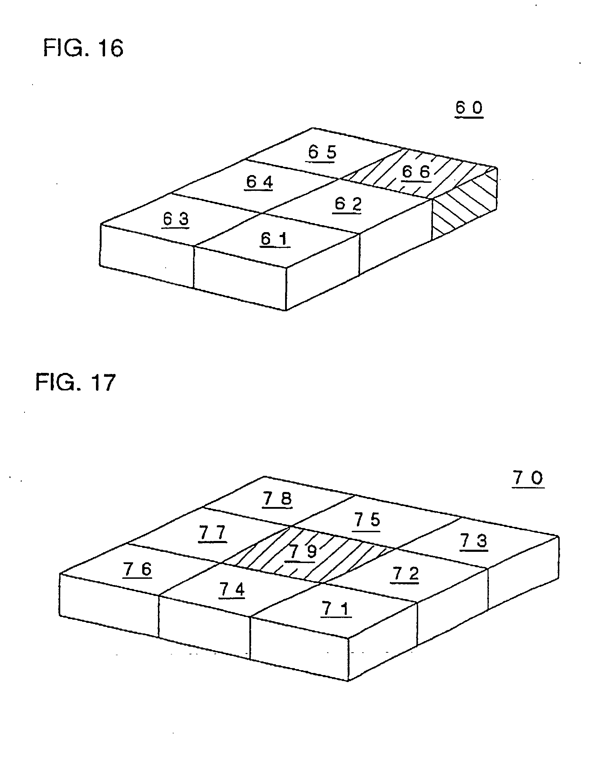

Figure 16 is an example of the layout of a high-frequency electronic component 60 composed of five passive elements 61 - 65.

As shown in Figure 16, a high-frequency electronic component 60 composed of five passive elements 61 - 65 can be given a quadrilateral planar shape by adding a dummy region 66.

One or more dummy regions may also be incorporated even when the number of passive elements used permits an overall quadrilateral layout.

Figure 17 is an example of the layout of a high-frequency electronic component 70 composed of eight passive elements 71 - 78.

Because it is composed of eight passive elements 71 - 78, the electronic component 70 can be given an overall quadrilateral layout without adding a dummy region. However, the addition of a dummy region 79 as shown in Figure 17 makes the overall planar shape of the electronic component 70 one that is easier to deal with. The layout with the dummy region 79 located in the middle of the electronic component 70 helps to further reduce interaction among the passive elements.

Although the foregoing embodiments were both explained taking as an example the case where the passive elements registered in the database have the same length per side, it is not absolutely necessary for all of the passive elements to have the same length per side. It is, for example, possible to register the passive elements in a number of series each consisting of members of a specific length per side such as 1.0 mm, 0.8 mm, 0.5 mm or 0.3 mm differing from those of the other series and to use passive elements belonging to one or more appropriate series in accordance with the electrical characteristics required by the high-frequency electronic component to be fabricated. In this case, the passive elements used in a high-frequency electronic component need not be selected from only one series but can be selected from two or more series and laid out to configure the high-frequency electronic component.

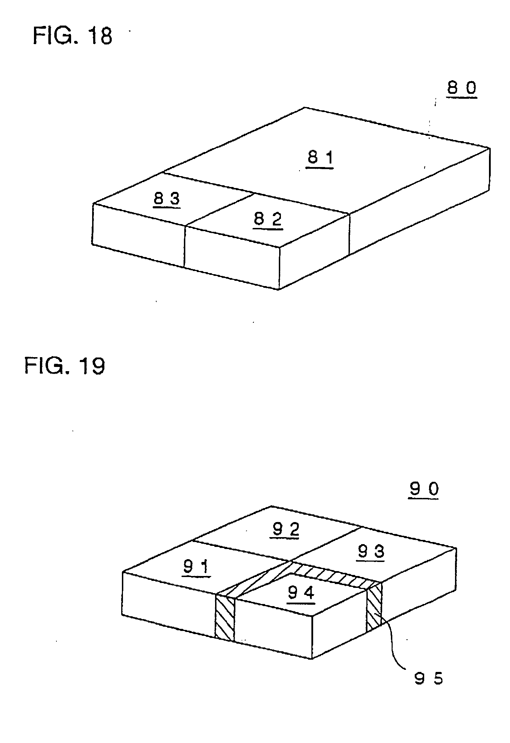

Figure 18 is an example of the layout of a high-frequency electronic component 80 composed of a passive element 81 selected from a series whose members measure 1.0 mm per side and passive elements 82, 83 selected from a series whose members measure 0.5 mm per side.

As shown in Figure 18, a high-frequency electronic component can be given an overall quadrilateral planar shape even when its passive elements are selected from two or more series.

In cases where an overall quadrilateral layout cannot be achieved by selecting passive elements from two or more series, the high-frequency electronic component can be given an overall quadrilateral planar shape by adding one or more dummy regions.

Figure 19 is an example of the layout of a high-frequency electronic component 90 composed of passive elements 91 - 93 selected from a series whose members measure 0.5 mm per side and a passive element 94 selected from a series whose members measure 0.3 mm per side.

As shown in Figure 19, when the high-frequency electronic component 90 cannot be given an overall quadrilateral layout owing to the use of the passive element 94 whose length per side is smaller than that of the other passive elements 91- 93, it can be given a quadrilateral planar shape overall by adding a dummy region 95. In this case, the interaction among the passive elements can be further reduced by, as shown in Figure 19, locating the passive element 94 measuring 0.3 mm per side at the corner and forming the dummy region at the remaining portion.

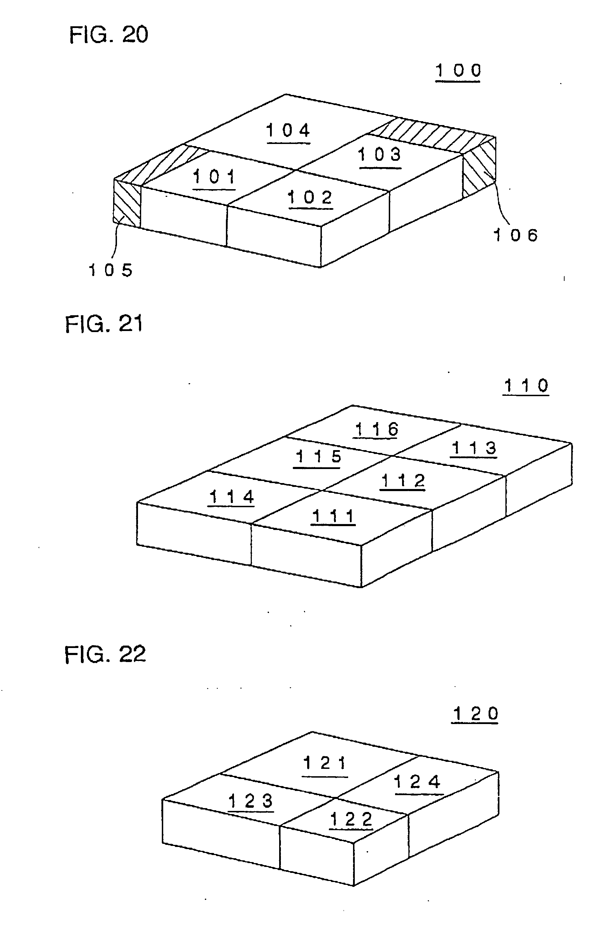

Figure 20 is an example of the layout of a high-frequency electronic component 100 composed of passive elements 101 - 103 selected from a series whose members measure 0.5 mm per side and a passive element 104 selected from a series whose members measure 0.8 mm per side.

As shown in Figure 20, when the high-frequency electronic component 100 cannot be given an overall quadrilateral layout owing to the use of the passive element 104 whose length per side is larger than that of the other passive elements 101 - 103, it can be given an overall quadrilateral planar shape by adding dummy regions 105, 106.

Although the foregoing embodiments were both explained talking as an example the case where all of the passive elements registered in the database are square in planar shape, it is not absolutely necessary for all of the passive elements to be square in planar shape and it is also possible to register passive elements that are rectangular in planar shape in the database.

Figure 21 is an example of the layout of a high-frequency electronic component 110 composed of six passive elements 111 - 116 all of which have a rectangular planar shape.

As shown in Figure 21, even though the passive elements 111 - 116 used are rectangular, the high-frequency electronic component 110 can nevertheless be given an overall quadrilateral planar shape by arranging them laterally (horizontally). In a case where the number of passive elements used makes it impossible to achieve an overall quadrilateral layout, the high-frequency electronic component can be given an overall quadrilateral planar shape by, as shown in Figures 15 and 16, adding one or more dummy regions. Moreover, as shown in Figure 17, one or more dummy regions may also be incorporated even when the number of passive elements used permits an overall quadrilateral layout.

When passive elements having a rectangular planar shape are used, it is not necessary to select all of the passive elements constituting the high-frequency electronic component from among ones having a rectangular planar shape and it is instead possible when configuring a high-frequency electronic component to lay out passive elements selected from among both ones having a rectangular planar shape and ones having a square planar shape. In such a case, the high-frequency electronic component is preferably given an overall quadrilateral planar shape by selecting the passive elements having a rectangular planar shape from among ones whose sides have lengths that are equal to, an integral multiple of, or the reciprocal of an integral multiple of the length per side of the passive elements having a square planar shape. For instance, in a case where passive elements having a square planar shape are registered in the data base in a number of series each consisting of members of a specific length per side among 1.0 mm, 0.8 mm, 0.5 mm and 0.3 mm that is different from those of the members of the other series, the passive elements of rectangular planar shape are preferably ones with side lengths such as 0.8 mm x 0.5 mm or 1.0 mm x 0.5 mm, i.e., ones whose sides are of lengths each equal to the length of one side of a passive element having a square planar shape, or ones with side lengths such as 0.4 mm x 0.5 mm or 0.4 mm x 0.6 mm, i.e., ones at least one of whose sides is of a length equal to an integral multiple or the reciprocal of an integral multiple of one side of a passive element having a square planar shape.

Figure 22 is an example of the layout of a high-frequency electronic component 120 composed of a passive element 121 selected from a series whose members measure 0.5 mm per side (square type), a passive element 122 selected from a series whose members measure 0.3 mm per side (square type), and rectangular type passive elements 122, 123 whose sides measure 0.5 mm x 0.3 mm.

As shown in Figure 22, the high-frequency electronic component 120 can be given an overall quadrilateral planar shape even when the used passive elements are a mixture of the passive elements 123, 124 of square type and the passive elements 123, 124 of rectangular type by setting the lengths of the sides of the passive elements having a rectangular planar shape to be equal to, and integral multiple of, or the reciprocal of an integral multiple of the length per side of the passive elements having a square planar shape. In the case where an overall quadrilateral layout cannot be achieved because of the number or sizes of the passive elements used, the high-frequency electronic component can be given an overall quadrilateral planar shape by adding one or more dummy regions. One or more dummy regions may also be added even when the number and sizes of the passive elements used do enable an overall quadrilateral layout to be achieved.

The present invention has thus been shown and described with reference to specific embodiments. However, it should be noted that the present invention is in no way limited to the details of the described arrangements but changes and modifications may be made without departing from the scope of the appended claims.

For example, in the database creation (phase-1) of the above-described embodiments, the characteristics (parameters) of the individual passive elements and the structures (patterns) corresponding thereto are obtained by deciding the virtual structures of the passive elements (step S10) and conducting magnetic field simulation (step S11), However, the characteristics (parameters) of the individual passive elements and the structures (patterns) corresponding thereto can instead be obtained by actually test-fabricating the passive elements and measuring their electrical characteristics. Although this approach provides more accurate data regarding the characteristics (parameters) of the individual passive elements and the structures (patterns) corresponding thereto, it requires much time to generate each set of data. Because of this, it is most preferable to generate the data by deciding the virtual structure (step S10) and conducting magnetic field simulation (S11), as in the foregoing embodiments, and then to interpolate the generated data as necessary by test-fabrication and measurement.

Although the foregoing embodiments were explained taking the design of a low-pass filter as an example, the present invention is not limited to the design of a low-pass filter and can also be applied to the design of other high-frequency electronic component circuits including, for example, filters, couplers and PIN switches. In such cases, electronic components such as PIN diodes and other semiconductor devices and/or capacitors, coils, resistors and other discrete components can, as required, be mounted on the upper surface (cap layer) of the high-frequency electronic component. When such electronic components are to be mounted on the upper surface (cap layer) of a high-frequency electronic component that, like the high-frequency electronic component of the former of the foregoing two embodiments, is not provided with wiring layers between its upper surface and element forming layers, it is preferable to form the wiring for connecting the passive elements incorporated in the multilayer substrate and the electronic component mounted on the cap layer in a dummy region. An advantage of providing the wiring in a dummy region is that it does not require any change in the metallization patterns of the element forming layers of the passive elements.

In each of the capacitor patterns 10, 130 explained in the foregoing, the metallizations (23 - 26, 141- 143) constituting the capacitor electrodes are formed across three layers, and in each of the coil patterns 30, 150 explained in the foregoing, the metallizations (43 - 46, 161 - 163) constituting the coil electrodes are formed across three layers. In a case where a larger constant value is required, however, four or more layers can be assigned as element forming layers. In such a case, the areas of the metallizations constituting the capacitor electrodes are preferably defined as follows.

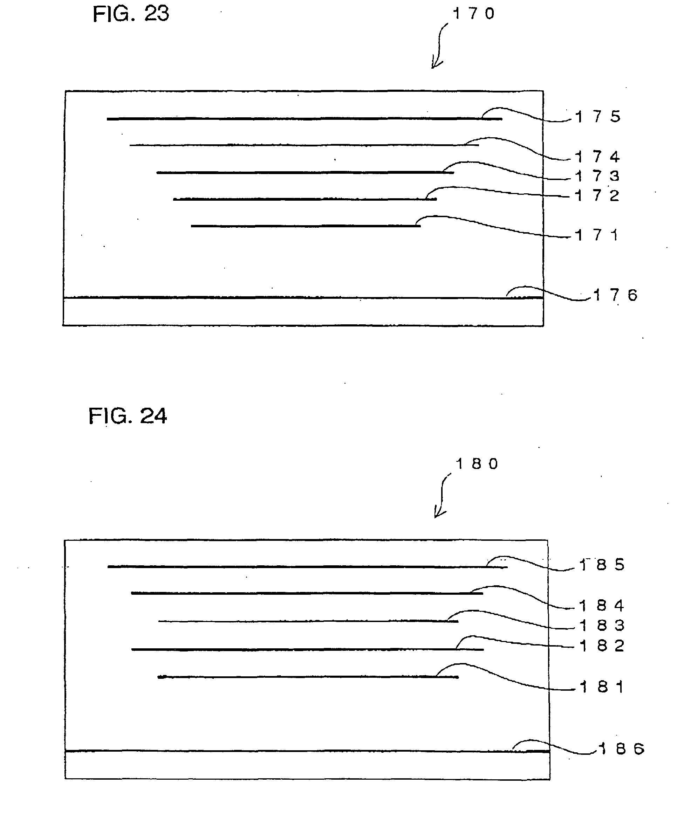

Figure 23 is a simplified sectional view showing a capacitor pattern 170 using five element forming layers.

As shown in Figure 23, among the metallizations 171- 175 constituting the capacitor electrodes in the capacitor pattern 170, the areas of the metallizations are defused to decrease in order from the metallization 175 farthest from the metallization 176 constituting the GND electrode to the metallization 171 closest to the metallization 176. In other words, the metallization 17 constituting the uppermost layer has the largest area and the whole of one surface of each of the other metallizations 171 - 174 is substantially covered by the metallization immediately above. The effect of this is the same as that in the coil patterns 10, 130 explained above.

Figure 24 is a simplified sectional view showing a capacitor pattern 180 using five element forming layers.

As shown in Figure 24, among the metallizations 181 - 185 constituting the capacitor electrodes in the capacitor pattern 180, the area of the metallization 185 farthest from the metallization 186 constituting the GND electrode is defined to be larger than that of the metallization 184 immediately below, the area of the metallization 184 is defined to be larger than that of the metallization 183 immediately below, the area of the metallization 183 is defined to be smaller than that of the metallization 182 immediately below, and the area of the metallization 182 is defined to be larger than that of the metallization 181 immediately below. In other words, among the metallizations constituting the capacitor electrodes, the three metallizations far from the metallization constituting the GND electrode are defined to have areas that, as in the case of the capacitor patterns 10, 130 explained above, grow smaller with increasing proximity to the GND electrode, while the other metallizations among the metallizations constituting the capacitor electrodes are defined to have areas that differ from those of adjacent metallizations and that are smaller than the area of the metallization farthest from the metallization constituting the GND electrode.

Also in this structure, the electric field generated at the edges of the capacitor electrodes constituted by the metallizations 181 - 185 is directed inward to effectively keep it from leaking laterally (horizontally). Moreover, the structure also makes it possible to obtain a larger capacitance value than that of the capacitor pattern 170 shown in Figure 23.

In the coil pattern 30 explained earlier, the relationship between the area of the region S1 enclosed by the metallizations 43 - 45 constituting the coil and the area of a region S2 outside thereof (extending to the edges of the dielectric substrates) is defined so that S2 ≥ S1. However, even a coil pattern in which S1 > S2 can be recorded in the database and used provided that in the passive element layout step (step S30) one or more added dummy regions and/or empty regions among adjacent passive elements (portions not metallized in the element forming layers) can be utilized to achieve a layout that makes S2 ≥ S1. In other words, the region S2 at the time of completion of the virtual layout of the passive element (step S30) can be defined as the region from the metallizations constituting the coil up to the edge of the dielectric substrates or up to the metallizations in the adjacent passive elements.

In the coil pattern 30' explained earlier, the shape of the coil constituted by the metallizations 43' - 45' is circular. However, the coil can instead be given an elliptical shape in accordance with the planar shape of the dielectric substrates.

In pattern design (phase 3) of the embodiments explained in the foregoing, the passive elements are first virtually laid out (step S30) and wiring is then formed among the laid-out passive elements (step S31). However, it is also possible to add ground capacity after completion of step 30 by further adding, at layers below the GND layer, a dielectric substrate formed with a ground capacity electrode and another GND layer.

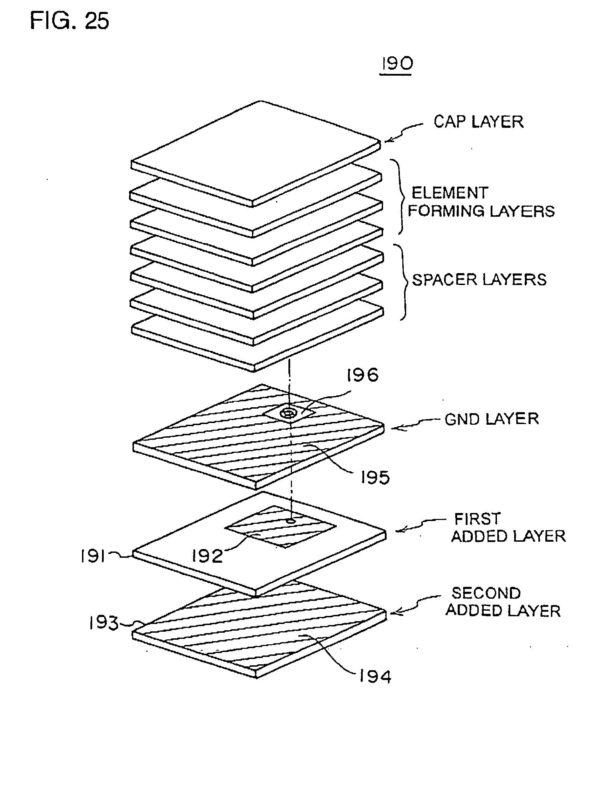

Figure 25 is an exploded perspective view showing a high-frequency electronic component 190 by way of an example imparted with such ground capacity.

In the high-frequency electronic component 190 shown in Figure 25, first and second added layers are provided below the GND layer constituting the original bottommost layer. The first added layer is composed of a dielectric substrate 191 and a metallization 192 constituting a ground capacity electrode formed thereon, and the second added layer is composed of a dielectric substrate 193 and a metallization 194 constituting a GND layer formed over substantially the whole surface thereof. A metallization 195 formed on the GND layer constituting the original bottommost layer is formed with a cutout 196 and the metallization 192 constituting the ground capacity electrode is connected via a through-hole formed in the cutout 196 by wiring formed in spacer layers.

The high-frequency electronic component 190 of this configuration enables easy formation of ground capacity of relatively large size. Since the first and second added layers are provided below the GND layer, they have substantially no effect on passive elements provided in the element forming layers.

The numbers of stacked dielectric substrates constituting the passive elements in the forgoing embodiments are merely examples. The number of stacked layers of the high-frequency electronic component according to the present invention is not limited to those set out in the foregoing embodiments. It is, for example, possible to use four or more dielectric substrates as element forming layers and to use four or more dielectric substrates as spacer layers. Moreover, the number of wiring layers is not limited but can be one or three or more.

In the latter of the foregoing two embodiments, the wiring among the passive elements is conducted in the wiring layers provided between the cap layer and the element forming layers. However, the wiring among the passive elements can instead be provided in both the wiring layers and the spacer layers.

As explained in the foregoing, the present invention provides a high-frequency electronic component wherein interaction between passive elements is reduced. The present invention also enables easy design of a high-frequency electronic component incorporating multiple passive elements in a multilayer substrate.

## Claims

1. A method of designing a high-frequency electronic component comprising:
a first step of specifying parameters required by passive elements included in circuitry of a high-frequency electronic component to be fabricated, separately for each passive element;
a second step of selecting the specified parameters and patterns corresponding thereto from a database storing parameters and patterns corresponding thereto of multiple passive elements;
a third step of virtually laying out the selected patterns laterally of one another; and
a fourth step of providing virtual wiring among the laid-out patterns.

2. A method of designing a high-frequency electronic component as claimed in claim 1, wherein the patterns selected in the second step are all multilayer substrates and each multilayer substrate includes a GND layer provided with a metallization constituting a GND electrode, element forming layers formed with metallizations constituting the body of a passive element, and spacer layers provided between the GND layer and the element forming layers.

3. A method of designing a high-frequency electronic component as claimed in claim 2, wherein once the patterns are laid out laterally of one another in the third step, the GND layers, the element forming layers and the spacer layers included in the patterns respectively form identical planes.

4. A method of designing a high-frequency electronic component as claimed in claim 2, wherein the fourth step is conducted at least in the spacer layers included in the patterns.

5. A method of designing a high-frequency electronic component as claimed in claim 2, wherein the multilayer substrate further comprises a cap layer provided on the side of the element forming layers opposite from the spacer layers, and wiring layers provided between the cap layer and the element forming layers.

6. A method of designing a high-frequency electronic component as claimed in claim 5, wherein the fourth step is conducted at least in the wiring layers included in the patterns.

7. A method of designing a high-frequency electronic component as claimed in claim 5, further comprising a fifth step of mounting an electronic component on the cap layer.

8. A method of designing a high-frequency electronic component as claimed in claim 2, wherein a pattern constituting a capacitor among the patterns selected in the second step includes at least first to third metallizations each formed on one of the element forming layers, the second metallization is provided between the first metallization and the third metallization, the whole of one surface of the first metallization is substantially covered by the second metallization and the whole of one surface of the second metallization is substantially covered by the third metallization.

9. A method of designing a high-frequency electronic component as claimed in claim 8, wherein the first metallization among the first to third metallizations is closest to the metallization constituting the GND electrode.

10. A method of designing a high-frequency electronic component as claimed in claim 9, wherein the pattern constituting the capacitor further includes a fourth metallization provided between the first metallization and the metallization constituting the GND electrode, and the fourth metallization has an area differing from that of the first metallization.

11. A method of designing a high-frequency electronic component as claimed in claim 2, wherein a pattern constituting a coil among the patterns selected in the second step is defined to make the relationship between the area of a region S1 of the element forming layers inward of metallizations constituting the coil body and the area of a region S2 outward thereof S2 ≥ S1.

12. A method of designing a high-frequency electronic component as claimed in claim 11, wherein the metallizations constituting the coil body have the shape of circular sections.

13. A method of designing a high-frequency electronic component as claimed in claim 1, wherein the planar shapes of the patterns selected in the second step are the same.

14. A method of designing a high-frequency electronic component as claimed in claim 1, wherein the planar shapes of the patterns selected in the second step are square.

15. A method of designing a high-frequency electronic component as claimed in claim 1, wherein a dummy region is added laterally of the patterns in the third step.

16. A method of designing a high-frequency electronic component as claimed in claim 2, further comprising a sixth step of, after conducting the third step, adding an added layer provided with a metallization constituting a capacity electrode adjacent to the GND layer of each pattern.

17. A high-frequency electronic component constituted of a multilayer substrate incorporating multiple passive elements, **characterized in that** the multiple passive elements are laid out laterally of one another in the multilayer substrate.

18. A high-frequency electronic component as claimed in claim 17, wherein the multilayer substrate includes a GND layer formed with a GND electrode, element forming layers formed with multiple passive elements, and spacer layers provided between the GND layer and the element forming layers, all input/output terminals of the multiple passive elements being led out to the spacer layers and wired at the spacer layers.

19. A high-frequency electronic component as claimed in claim 17, wherein the multilayer substrate includes a GND layer formed with a GND electrode, element forming layers formed with multiple passive elements, and wiring layers provided on the side of the element forming layers opposite from the GND layer, all input/output terminals of the multiple passive elements being led out to the wiring layers and wired at the wiring layers.

20. A high-frequency electronic component as claimed in claim 18, wherein the multiple passive elements include a capacitor, which capacitor includes at least first to third metallizations each formed on one of the element forming layers, the second metallization is provided between the first metallization and the third metallization, the whole of one surface of the first metallization is substantially covered by the second metallization and the whole of one surface of the second metallization is substantially covered by the third metallization.

21. A high-frequency electronic component as claimed in claim 20, wherein the first metallization among the first to third metallizations is closest to the metallization constituting the GND electrode.

22. A high-frequency electronic component as claimed in claim 21, wherein the capacitor further includes a fourth metallization provided between the first metallization and the GND electrode, and the fourth metallization has an area differing from that of the first metallization.

23. A high-frequency electronic component as claimed in any one of claims 18 to 22, wherein the multiple passive elements include a coil, in which coil the relationship between the area of a region S1 of the element forming layers inward of metallizations constituting the coil body and the area of a region S2 from the metallizations constituting the coil body up to the edge of the multilayer substrate or up to metallizations constituting adjacent passive elements is defined as S2 ≥ S1.

24. A high-frequency electronic component as claimed in claim 23, wherein the metallizations constituting the coil have the shape of circular sections.

25. A high-frequency electronic component as claimed in claim 17, wherein an electronic component is mounted on the upper surface of the multilayer substrate.

26. A high-frequency electronic component as claimed in claim 18, wherein the multilayer substrate further comprises an added layer provided adjacent to the GND electrode and formed with a capacity electrode whose mate electrode is the GND electrode.

27. A high-frequency electronic component constituted of a multilayer substrate incorporating multiple passive elements, **characterized in that** the multiple passive elements include a capacitor, which capacitor includes at least first to third metallizations, the second metallization is provided between the first metallization and the third metallization, the whole of one surface of the first metallization is substantially covered by the second metallization and the whole of one surface of the second metallization is substantially covered by the third metallization.

28. A high-frequency electronic component as claimed in claim 27, wherein the multilayer substrate includes a GND layer formed with a GND electrode over substantially the whole surface thereof and the first metallization among the first to third metallizations is closest to the GND electrode.

29. A high-frequency electronic component as claimed in claim 28, wherein the capacitor further includes a fourth metallization provided between the first metallization and the GND electrode, and the fourth metallization has an area differing from that of the first metallization.

30. A high-frequency electronic component constituted of a multilayer substrate incorporating multiple passive elements, **characterized in that** the multiple passive elements include a coil, in which coil the relationship between the area of a region S1 inward of metallizations constituting the coil body and the area of a region S2 from the metallizations constituting the coil body up to the edge of the multilayer substrate or up to metallizations constituting adjacent passive elements is defined as S2 ≥ S1.

31. A high-frequency electronic component as claimed in claim 30, wherein the metallizations constituting the coil body have the shape of circular sections.
